# EUROPEAN PATENT APPLICATION

(11) **EP 2 388 807 A1**
(43) Date of publication of application: **23.11.2011**
(21) Application number: 10163488.9
(22) Date of filing: 20.05.2010
(51) Int. Cl.: H01L 21/60, H01L 23/00, H01L 23/367

(54) **Semiconductor die with venting channel**

(71) Applicant: NXP B.V., 5656 AG Eindhoven (NL)
(72) Inventor: Dirks, Peter Adrianus Jacobus, 5656 AE Eindhoven (NL)
(74) Representative: Schouten, Marcus Maria

(57) **Abstract**

A semiconductor die comprising one or more venting channels is disclosed. The venting channels terminate at top and bottom surfaces of the die so as to provide fluid communication between the top and bottom surfaces of the die. The venting channels is located in a region of the die free from any integrated circuit elements. A path is provided by which entrapped gases can escape.
Voids formed in a molten eutectic mixture can pass from the bottom surface of the die through the venting channels to the surrounding atmosphere. The presence of voids is thereby reduced.

## Description

The invention relates to a semiconductor die of the type suitable for attachment to a substrate using a eutectic. It also relates to a method for attaching such a die to a substrate.

Eutectic bonding is a well-known technique for attaching semiconductor dice and a substrate. In this technique a eutectic mixture, typically of gold and silicon, is melted in the joint between die and substrate and then allowed to solidify to attach the die to the substrate. The melting point of a 97% gold : 3% silicon eutectic mixture is 363°C.

In order to attach a die to a substrate, the substrate is heated to a temperature just below the eutectic mixture's melting point. A eutectic preform is then placed on the substrate with the die on top and the die is caused to vibrate rapidly in a so-called scrubbing process. This causes the temperature of the eutectic preform to rise to a point just above the melting point. The scrubbing is then stopped, allowing the eutectic mixture to solidify, thereby bonding the die to the substrate. Rather than use a eutectic preform, it is also possible to perform the technique with a die having a eutectic mixture plated on its underside.

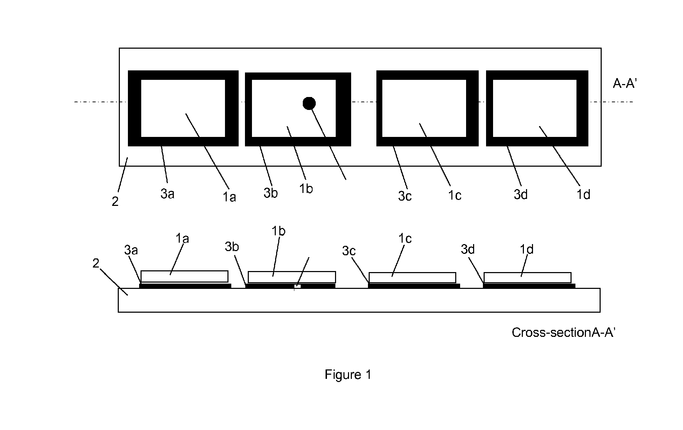

Figure 1 shows a set of four dice 1 a-1 d attached to a substrate 2 using respective eutectic preforms 3a-3d. In the cross-section, a void 4 in the eutectic preform 3b can be seen underneath die 1 b. A corresponding hotspot 5 is seen in the plan view.

One of the problems inherent with this technique is that voids can form in the joint. This leads to poor thermal contact between the die and the substrate, which can cause overheating and subsequent failure of the device integrated in the die. US6,399,182 proposed the provision of grooves in the substrate, which allow entrapped gases to escape during the formation of the bond. This reduces the presence of voids, but it comes at the expense of extra costly processing of the substrate to provide the grooves.

US5,773,362 discloses roughening the mating surfaces of a die and heatsink before bonding takes place. However, this is done with the intention of preventing delamination of the die from the heatsink, rather than reducing the occurrence of voids. Again, it introduces another process step, which is costly.

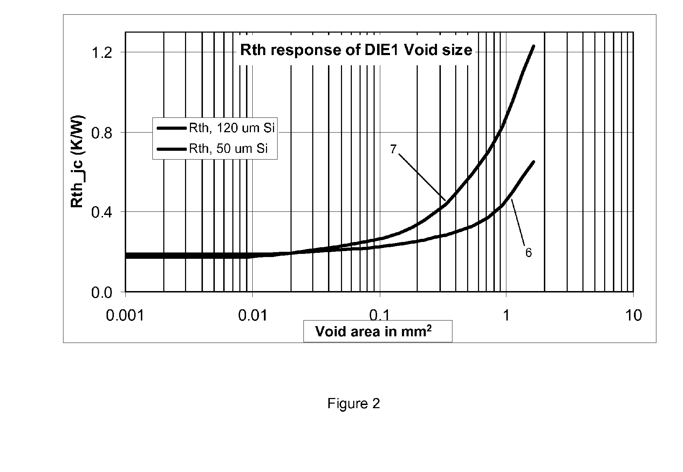

The problems with overheating are exacerbated in the case of broadcast radiofrequency (RF) power products, which are often made on thinner dice (such as 50µm and 35µm thick dice) in order to improve electrical performance and improve thermal conductivity through the device. This is necessary with these devices because they have a very high operating temperature. However, these thinner dice have a lower lateral thermal conductivity, and the presence of voids can easily lead to destruction of a device. Figure 2 shows the relationship between thermal resistance and void area for a 120µm (trace 6) and a 50µm (trace 7) silicon die. It is clearly visible that the thermal resistance is significantly higher for the 50µm die than for the 120µm die as the void area increases. There is a need to use thinner dice without the reliability problems caused by the presence of voids in the eutectic bond.

According to a first aspect of the invention, there is provided a semiconductor die comprising one or more venting channels terminating at top and bottom surfaces of the die so as to provide fluid communication between the top and bottom surfaces of the die, wherein the or each venting channel is located in a region of the die free from any integrated circuit elements.

Hence, the invention provides a path by which entrapped gases can escape. Thus, voids formed in the molten eutectic mixture can pass from the bottom surface of the die, through the venting channels to the surrounding atmosphere. The presence of voids is thereby reduced, and the use of larger, thinner dice becomes more reliable. This can be achieved at very little or no additional cost as the venting channels can be formed during the normal processing of the die, for example, by etching, drilling or laser ablation.

The integrated circuit elements referred to above may include any passive or active components integrated in the die, metallisation or polysilicon used for interconnection, isolating regions on the die, or any other diffused or deposited features necessary for correct operation of the circuit integrated into the die.

The die and substrate are typically manufactured from silicon.

Typically, the die comprises a plurality of said venting channels disposed in a series of rows spaced apart by a first predetermined distance, the venting channels within a row being spaced apart by the first predetermined distance.

Alternatively, the die may comprise a plurality of said venting channels disposed in a series of rows in first and second regions of the die, the rows in the first region of the die being spaced apart by a first predetermined distance, the rows in the second region of the die being spaced apart by a second predetermined distance, and the venting channels within the rows in the first and second regions being spaced apart by the first and second predetermined distances respectively. This allows the density of venting channels to be increased in areas of the die that will operate at a higher temperature. By increasing the density of venting channels, the size of void that may remain is reduced, thereby reducing the thermal resistance in that area of the die.

Corresponding venting channels in adjacent rows will normally lie on the same axis.

The or each venting channel typically has a longitudinal axis, which intersects the top and bottom surfaces at right angles.

In this case, the venting channels will normally be cylindrical and centered on the longitudinal axis.

In a preferred embodiment, the semiconductor die further comprises one or more transverse venting channels formed in the bottom surface of the die and terminating at a first end at the periphery of the bottom surface.

Thus, the transverse venting channels lie in the same plane as the bottom surface. They will be placed away from any integrated circuit elements, although typically the bottom surface will be free of such integrated circuit elements.

Typically, the or each transverse venting channel terminates at a second end at the periphery of the bottom surface. Of course, the first and second ends will normally lie at different points on the periphery of the bottom surface.

Preferably, the die comprises a plurality of said transverse venting channels arranged in two orthogonally disposed arrays to form a grid pattern. In the case that the die is rectangular or square, the grid would be arranged such that transverse venting channels lie at right angles to the edges of the die.

The transverse venting channels are normally spaced apart equidistantly. Thus, the plurality of said transverse venting channels in each of the two orthogonally disposed arrays may be spaced apart by a first predetermined distance.

Alternatively, the plurality of said transverse venting channels in each of the two orthogonally disposed arrays are spaced apart by a first predetermined distance in a first region of the die and by a second predetermined distance in a second region of the die. This allows the density of transverse venting channels to be increased in areas of the die that will operate at a higher temperature. By increasing the density of transverse venting channels, the size of void that may remain is reduced, thereby reducing the thermal resistance in that area of the die.

In an especially preferred embodiment, one of said venting channels terminates at each intersection of the orthogonally disposed arrays of transverse venting channels.

In accordance with a second aspect of the present invention, there is provided a silicon substrate to which one or more semiconductor die according to the first aspect are attached by a silicon-gold eutectic.

In accordance with a third aspect of the invention, there is provided a method of attaching a semiconductor die according to the first aspect to a silicon substrate, the method comprising placing the die above the substrate at a placement location, heating the silicon substrate to a first temperature, vibrating the or each semiconductor die so as to raise the temperature of a eutectic disposed between the die and the substrate to a second temperature at or above its melting point, and releasing the die at an attachment location, whereby the temperature of the eutectic falls to the first temperature such that the eutectic solidifies.

The placement and attachment locations may be the same.

Typically, the eutectic is a gold-silicon alloy, such as a 97% gold : 3% silicon alloy. In this case, the second temperature is at or above 363°C, and the first temperature will be set just below this point.

In one variant, the die is moved between the placement and attachment locations in a convoluted path during the vibration such that the venting channels together sweep across substantially the whole area of the bottom surface of the die.

In another variant (when transverse venting channels are provided), the die is moved in a straight line between the placement and attachment locations during the vibration such that the transverse venting channels together sweep across substantially the whole area of the bottom surface of the die.

Preferably, the method further comprises applying a vacuum to one or more of the venting channels where it terminates at the top surface.

Examples of the invention will now be described in detail with reference to the accompanying drawings, in which:
Figure 1 shows four dice attached to a substrate using a prior art technique, and the presence of a void beneath one of the dice;
Figure 2 shows the relationship between thermal resistance and void size;
Figure 3 shows a set of four dice according to a first embodiment of the invention in plan view and in cross-section;
Figure 4 shows a path followed by a vent pipe of one of the dice of Figure 3 during the scrubbing process;
Figure 5 shows a set of four dice according to a second embodiment of the invention in plan view and in cross-section; and
Figure 6 shows a path followed by a vent pipe of one of the dice of Figure 5 during the scrubbing process.

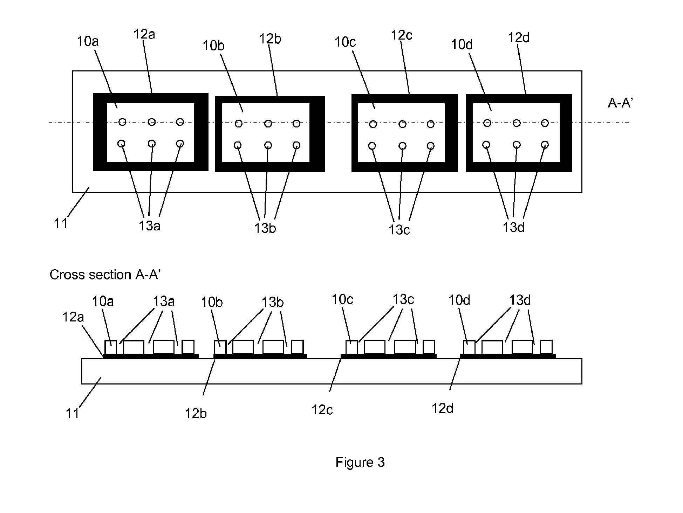

Figure 3 shows a first embodiment of a set of semiconductor dice according to the invention. In particular, Figure 3 shows four silicon dice 10a-10d attached to a silicon substrate 11 by way of respective eutectic preforms 12a-12d. The eutectic preforms are made of an alloy of 3% silicon and 97% gold. Instead of eutectic preforms 12a-12d, the four silicon dice 10a-10d may be plated on their bottom surfaces with a eutectic alloy of 3% silicon and 97% gold.

Each of the dice 10a-10d is provided with six vent pipes 13a-13d passing through the respective die 10a-10d from the top to the bottom surface. The vent pipes 13a-13d are spaced apart from each other by 1 mm.

In order to attach one of the dice, for example die 10a, it is picked up using a die collet by application of a vacuum. It is then placed on the substrate 11, which has been heated to a temperature just below the melting point of the eutectic bonding mixture (363°C for the gold-silicon alloy referred to above). As explained above, either a eutectic preform may be interposed between the die 10a and the substrate 11 or the eutectic alloy may be plated on the bottom surface of the die 10a.

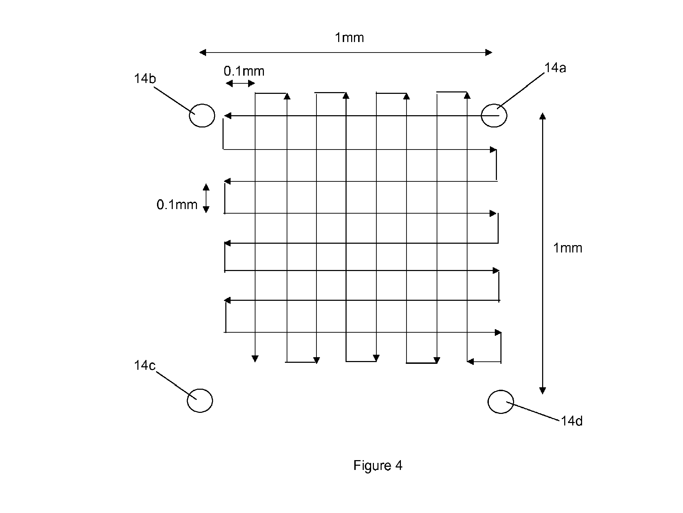

The scrubbing process is then commenced to raise the temperature of the eutectic alloy to just above its melting point. However, in this case the scrubbing pattern is chosen to ensure that the vent pipes 13a sweep across substantially the whole area of the bottom surface of the die 10a. A suitable pattern is shown in Figure 4, in which the vent pipe 14a follows a convoluted path during the scrubbing process to sweep across the entire area bounded by the vent pipes 14a-14d. It comes to rest at the position where the vent pipe 14c was originally placed on the die 10a. As the vent pipes 14a-14d sweep across the substrate 11, any voids that they encounter are allowed to escape through the vent pipes 14a-14d. Thus, very few voids will remain and these will be of a very small size due to the fine pitch of the scrubbing pattern. The vacuum applied by the die collet assists in evacuating the voids through the vent pipes 14a-14d. The diameter of the vent pipes 14a-14d is chosen to ensure that the surface tension of the molten eutectic mixture prevents it from passing through the vent pipes 14a-14d, whilst allowing the free passage of the void gases.

The vent pipes 13a-13d can be made by drilling, etching or laser ablation, and it is easier to make vent pipes 13a-13d in the thinner dies currently favoured. The vent pipes 13a-13d must be placed at areas on the die that are free from functional elements, such as transistors or interconnections. However, at a pitch of 1 mm, the vent pipes 13a-13d do not occupy too much die area and it is relatively easy to layout the functional elements around the vent pipes 13a-13d.

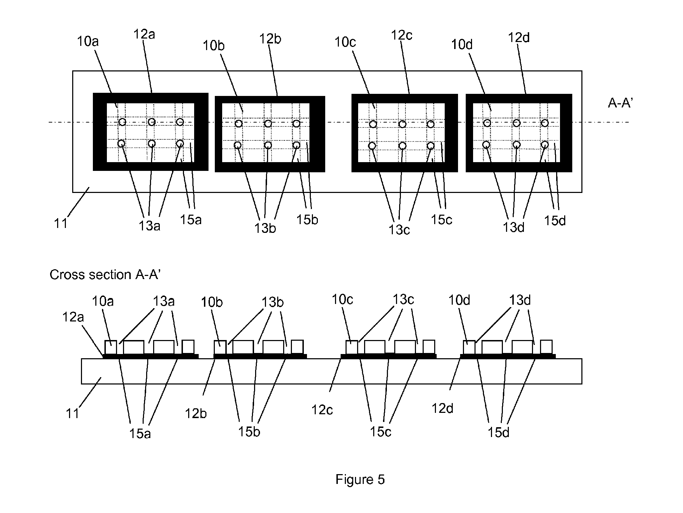

Figure 5 shows a second embodiment, which is similar to the first embodiment but includes additional venting channels 15a-15d formed in the bottom surface of the dice 10a-10d. The venting channels 15a-15d are formed by gang sawing when the silicon wafer is split into separate dies 15a-15d. Thus, the venting channels 15a-15d are formed simultaneously with the separation of the dice 10a-10d and adds no incremental cost to the processing.

The venting channels 15a-15d are laid out in two orthogonally disposed arrays to form a grid pattern. Each end of each venting channel 15a-15d terminates at the edge of the respective die 10a-10d. At each intersection of venting channels 15a-15d of the two arrays, a vent pipe 13a-13d is located.

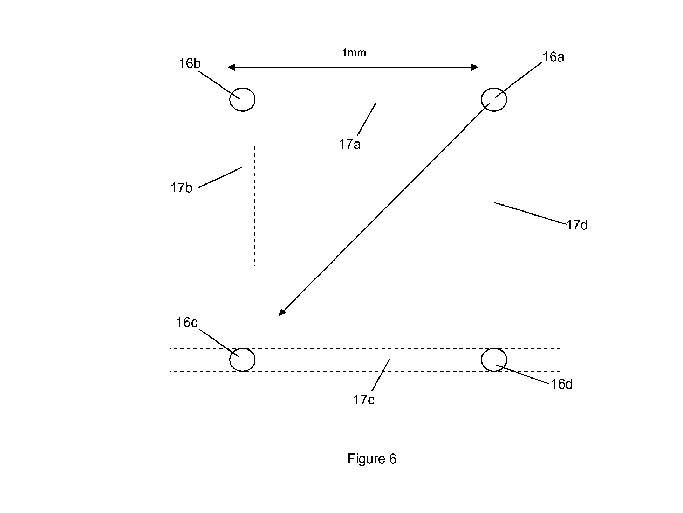

The attachment process is the same as for the first embodiment of Figure 3 except that the scrubbing pattern is as shown in Figure 6. In this pattern, the vent pipe 16a moves in a straight line to vent pipe 16c during the scrubbing. This simpler scrubbing pattern is possible as the venting channels 17a-17d provide another escape route for entrapped void gases and the venting channels 17a-17d naturally sweep over the whole area of the bottom surface of the bottom surface of the die as the vent pipe 16a follows this path.

It is possible that there may be a significant operating temperature gradient in the die. Typically, the middle of the die is hotter than the outer regions. Also, high power dissipation of some transistors may increase the temperature of the die in the region of that transistor. Thus, the size of voids that can be tolerated in such hotter regions is smaller than elsewhere on the die. The pitch between adjacent vent pipes and/or venting channels can be increased in such hotter regions to overcome this problem by increasing the density of escape routes for the trapped void gases.

Other variations to the disclosed embodiments can be understood and effected by those skilled in the art in practising the claimed invention, from a study of the drawings, the disclosure, and the appended claims. In the claims, the word "comprising" does not exclude other elements or steps, and the indefinite article "a" or "an" does not exclude a plurality. A single processor or other unit may fulfill the functions of several items recited in the claims. The mere fact that certain measures are recited in mutually different dependent claims does not indicate that a combination of these measured cannot be used to advantage. Any reference signs in the claims should not be construed as limiting the scope.

## Claims

1. A semiconductor die comprising one or more venting channels terminating at top and bottom surfaces of the die so as to provide fluid communication between the top and bottom surfaces of the die, wherein the or each venting channel is located in a region of the die free from any integrated circuit elements.

2. A semiconductor die according to claim 1, wherein the die comprises a plurality of said venting channels disposed in a series of rows spaced apart by a first predetermined distance, the venting channels within a row being spaced apart by the first predetermined distance.

3. A semiconductor die according to claim 1, wherein the die comprises a plurality of said venting channels disposed in a series of rows in first and second regions of the die, the rows in the first region of the die being spaced apart by a first predetermined distance, the rows in the second region of the die being spaced apart by a second predetermined distance, and the venting channels within the rows in the first and second regions being spaced apart by the first and second predetermined distances respectively.

4. A semiconductor die according to any of the preceding claims, wherein the or each venting channel has a longitudinal axis, which intersects the top and bottom surfaces at right angles.

5. A semiconductor die according to any of the preceding claims, further comprising one or more transverse venting channels formed in the bottom surface of the die and terminating at a first end at the periphery of the bottom surface.

6. A semiconductor die according to claim 5, wherein the or each transverse venting channel terminates at a second end at the periphery of the bottom surface.

7. A semiconductor die according to claim 6, wherein the die comprises a plurality of said transverse venting channels arranged in two orthogonally disposed arrays to form a grid pattern.

8. A semiconductor die according to claim 7, wherein the plurality of said transverse venting channels in each of the two orthogonally disposed arrays are spaced apart by a first predetermined distance.

9. A semiconductor die according to claim 7, wherein the plurality of said transverse venting channels in each of the two orthogonally disposed arrays are spaced apart by a first predetermined distance in a first region of the die and by a second predetermined distance in a second region of the die.

10. A semiconductor die according to any of claims 7 to 9, wherein one of said venting channels terminates at each intersection of the orthogonally disposed arrays of transverse venting channels.

11. A silicon substrate to which one or more semiconductor die according to any of the preceding claims are attached by a silicon-gold eutectic.

12. A method of attaching a semiconductor die according to any of claims 1 to 10 to a silicon substrate, the method comprising placing the die above the substrate at a placement location, heating the silicon substrate to a first temperature, vibrating the or each semiconductor die so as to raise the temperature of a eutectic disposed between the die and the substrate to a second temperature at or above its melting point, and releasing the die at an attachment location, whereby the temperature of the eutectic falls to the first temperature such that the eutectic solidifies.

13. A method according to claim 12, wherein the die is moved between the placement and attachment locations in a convoluted path during the vibration such that the venting channels together sweep across substantially the whole area of the bottom surface of the die.

14. A method according to claim 12 when dependent on any of claims 5 to 10, wherein the die is moved in a straight line between the placement and attachment locations during the vibration such that the transverse venting channels together sweep across substantially the whole area of the bottom surface of the die.

15. A method according to any of claims 12 to 14, further comprising applying a vacuum to one or more of the venting channels where it terminates at the top surface.
